# EUROPEAN PATENT APPLICATION

(11) **EP 1 039 507 A2**
(43) Date of publication of application: **27.09.2000**
(21) Application number: 00302411.4
(22) Date of filing: 24.03.2000
(51) Int. Cl.: H01L 21/00, H01L 21/70

(54) **Production line for semiconductor devices**

(30) Priority: 26.03.1999 JP 8265399
(71) Applicant: Innotech Corporation, Yokohama-shi, Kanagawa-ken 222-8580 (JP)
(72) Inventor: Doi, Takeshi, Yokohama-Shi, Kanagawa-ken 222-8580 (JP)
(74) Representative: Carpmael, John William Maurice

(57) **Abstract**

Provision of a semiconductor-device production line capable of efficiently using a conveying route, effectively operating treatment systems and improving the production efficiency. In the semiconductor-device production line having a section in which a plurality of treatment systems (M) are arrayed in line and a conveying route (1) provided along the treatment systems, buffer ports (P) are respectively provided at positions corresponding to the predetermined treatment systems of all the treatment systems (M) and near the conveying route (1), so that carriages (2) loaded with the wafer substrates and traveling on the conveying route are temporarily moved to the buffer port.

## Description

### BACKGROUND OF THE INVENTION

### 1. FIELD OF THE INVENTION

This invention relates to a production line for manufacturing semiconductor devices.

### 2. DESCRIPTION OF RELATED ART

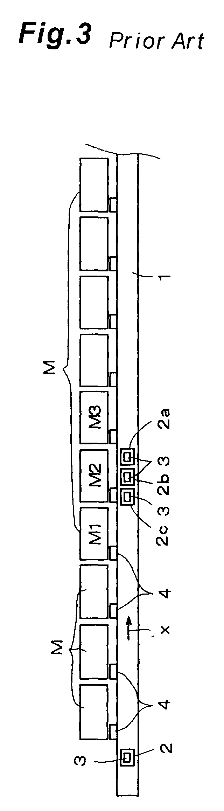

FIG. 3 shows a production line for semiconductor devices, in which a plurality of treatment systems M are arrayed in a line and a conveying route 1 is provided along the treatment systems M.

The treatment systems M are for forming individual films on a wafer substrate, which are, for example, a spattering equipment, an impurity diffusion equipment and a photolithography system.

On the conveying route 1, substrate carriages 2 as means for conveying the wafer substrates to each treatment system M are provided to move in a direction X illustrated with the arrow. On the substrate carriage 2, a clean box 3 containing the wafer substrate is mounted. The substrate carriage 2 is controlled to move and stop by a controller CPU (not shown).

The treatment systems M are aligned in order of treatments necessary for the wafer substrate which is carried in the direction X by the substrate carriage 2. In other words, the treatment systems M are arranged corresponding to the process steps for forming films. Accordingly, when the same treatment is repeated for forming different films on the wafer substrate, the treatment systems M of the same sort may be respectively arranged at different positions.

In the production line, typically, the treatment systems M are arranged to be able to manufacture various types of semiconductor devices. In other words, on a single production line both treatment systems M used for processing several types of semiconductor device and less general treatment systems M only used for processing specific types are variously arranged. All the treatment systems M in the production line are not required for all types of semiconductor device, so that the substrate carriage 2 selects only the treatment systems required for the loaded wafer substrate and carries it thereto.

A method for manufacturing the semiconductor devices in the above production line will be briefly mentioned.

A substrate carriage 2 loading a clean box 3 containing wafer substrate moves on the conveying route 1 in the direction X, and stops at a treatment system M required for treating the loaded wafer substrate. When the substrate carriage 2 stops, the treatment system M receives the wafer substrate from the clean box 3 and treats it. Each treatment system M has a mechanism for taking the wafer substrate loaded in the clean box 3 without exposing it to the atmosphere.

The substrate carriage 2 moves in the direction X while selecting the required treatment systems M, so that the wafer substrate undergoes the necessary treatments. When the substrate carriage 2 reaches the right end of the conveying route 1, all treatment processes in the production line complete.

Meanwhile, in the above production line, a plurality of the substrate carriages 2 are typically provided on the conveying route 1 for treating the wafer substrates in sequence. Thus, if there is a treatment system having a slower produce speed among the treatment systems, some substrate carriages 2 form a line in front of the treatment system.

For easier understanding, symbols 2a, 2b and 2c respectively represent a few of substrate carriages 2 to show its position and similarly symbols M1, M2 and M3 represent some treatment systems M.

In the production line shown in FIG. 3, for example, if the process speed of the treatment system M2 is slower than those of the treatment systems M1 and M3 positioned before and after the treatment system M2, the substrate carriages 2a, 2b and 2c wait for treatment in the treatment system M2 and form a line on the conveying route 1. In other words, while the wafer substrate carried by the substrate carriage 2a positioned at the front of the line is treated in the treatment system M2, the substrate carriages 2b and 2c following the unloaded substrate carriage 2a must wait.

If the line of the substrate carriages 2a, 2b and 2c on the conveying route 1 is extended extremely, they may obstruct other substrate carriages from carrying wafer substrates to the treatment system M1. In order to avoid such an obstacle, a space between the treatment system M1 and the treatment system M2 must be extended, resulting in a longer conveying route 1.

As described above, if each space between the adjacent treatment systems is extended due to the treatment system having a slow process speed, the entire length of conveying route 1 is extended, thereby the distance traveled by the substrate carriage 2 is also longer, resulting in inefficient work.

Moreover, the treatment systems M in the production line are arranged to process various types of the semiconductor devices.

Each type of the semiconductor device requires different treatments. Thus the substrate carriage 2 must select only the treatment systems necessary for the type and carry the wafer substrate thereto. For example, in FIG. 3, if the substrate carriage 2c carries the wafer substrate of a type not needing the treatment in the treatment system M2, the substrate carriage 2c must carry to the treatment system M3 after the treatment system M1. However, the aforementioned line of the substrate carriages 2a and 2b is formed in front of the treatment system M2 as shown in FIG. 3, so that the substrate carriage 2c cannot move to the treatment system M3 until the substrate carriages 2a and 2b are advanced.

Even if the treatment system M3 has no treating wafer substrate, the substrate carriage 2c must wait for the substrate carriages 2a and 2b to complete the treatment in system M2, and during all that time the treatment system M3 does not operate.

In consequence, on the whole, the processing time is longer and a net working rate of treatment systems is decreased.

### SUMMARY OF THE INVENTION

It is an object of the present invention that substrate carriages do not form a line in front of a certain treatment system to obstruct the following substrate carriages.

It is another object of the present invention to efficiently use a conveying route and effectively operate treatment systems so as to produce more efficient production.

To attain the above objects, the first invention is premised on that a production line for semiconductor devices, having a section in which a plurality of treatment systems are arrayed in line and a conveying route provided along the treatment systems.

The production line for semiconductor devices is characterized by buffer ports respectively provided at positions corresponding to the predetermined treatment systems of all the treatment systems and near the conveying route, for allowing carriages loaded with wafer substrates and travelling on the conveying route to be temporarily moved thereto.

The second invention is characterized in that, in the first invention, the buffer ports are respectively provided at positions corresponding to the treatment systems, each having a slow process speed, of all the treatment systems, and near the conveying route.

The third invention is characterized in that, in the first or second invention, the conveying route includes a belt conveyor.

Regarding the aforementioned section in which a plurality of treatment systems are arrayed in line, the present invention includes a section in which all the treatment systems are aligned and a section in which parts of the treatment systems are aligned.

### BRIEF DESCRIPTION OF THE DRAWINGS

FIG. 1 is a diagram showing a production line for semiconductor devices of the first embodiment in accordance with the present invention.
FIG. 2 is a diagram showing a production line for semiconductor devices of the second embodiment.
FIG. 3 is a diagram showing a conventional production line for semiconductor devices.

### DETAILED DESCRIPTION OF THE PREFERRED EMBODIMENTS

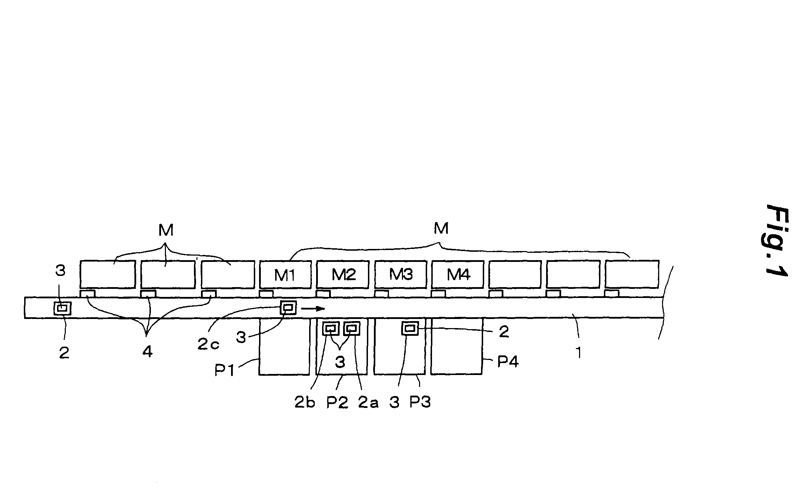

The first embodiment shown in FIG. 1 differs from prior art in that a plurality of buffer ports P1 to P4 are provided along the conveying route 1 and across from the treatment systems M. Each buffer port P1, P2, P3, P4 is designed so that a plurality of substrate carriages 2 carrying the wafer substrates contained in the respective clean boxes 3 are temporarily moved thereto for standby. Similarly to the prior art, the substrate carriage 2 is moved and stopped by a command from CPU as a controller (not shown).

Each treatment system M is assigned with an address for determining its position. Such identifications ID4 are installed along the conveying route 1, each which is like a sign indicating an address.

The substrate carriage 2 has an ID sensor (not shown) for reading the identifications ID4. The identification ID4 is made of material, such as bar-coding, read by the substrate carriage 2 moving on the conveying route 1. Thus, the substrate carriage 2 loading the wafer substrate detects its position by reading the identification ID4 through the ID sensor. The substrate carriage 2 sends the detection signals to the CPU while moving on the conveying route 1.

Thus, the CPU tracks the positions of each substrate carriage 2 by receiving the detection signals of the identifications ID4 from the substrate carriage 2.

The CPU stores all identifications of the treatment systems necessary for each type of the semiconductor devices, and sends a stop command to each substrate carriage 2 whenever it reaches each identification of the required treatment systems.

In the first embodiment, hence, the substrate carriage 2 is a carriage of the present invention.

A method for manufacturing the semiconductor devices in the above production line will be now described.

The substrate carriages 2a to 2c move in the direction X illustrated with the arrow while reading the identifications ID4, and respectively stop at the required treatment systems in response to commands of the CPU.

For example, when the substrate carriage 2a stops at the treatment system M2, the treatment system M2 receives the wafer substrate from the clean box 3 on the substrate carriage 2a and starts the treatment. During the treatment on the wafer substrate in the treatment system M2, as shown in FIG. 1, the substrate carriage 2a with the clean box 3 is temporarily moved to the buffer port P2 for standby.

Continuously, the substrate carriage 2b carrying the wafer substrate requiring the treatment in the treatment system M2 reaches the treatment system M2. However, while the treatment system M2 is in operation for the wafer substrate of carriage 2a, the substrate carriage 2b must wait, and also is temporarily moved to the buffer port P2. Since the substrate carriages 2a and 2b are in the buffer port P2, no obstacle to advance of the following substrate carriages 2 is on the conveying route 1.

Therefore, if the next substrate carriage 2c carries the wafer substrate of a type not requiring the treatment in the treatment system M2, it can straight carry the wafer substrate to the treatment system M3 without stopping at the treatment system M2. Similarly, the substrate carriage 2c waits in the buffer port P3 while the carried wafer substrate is treated in the treatment system M3.

On the other hand, after treatment, the wafer substrate in the treatment system M2 is put back in the clean box 3, and returned to the substrate carriage 2a. After that, the treatment system M2 receives the next wafer substrate from the substrate carriage 2b. The substrate carriage 2a moves to the next treatment system, e.g., M3. If the treatment system M3 is in use, the substrate carriage 2a moves to the buffer port P3 for standby, whereas if the treatment system M3 is not in use, it receives the wafer substrate from the carriage 2a for treating.

In short, the substrate carriage 2 conveys the wafer substrate to the required treatment systems M1, M2, M3 and/or M4 and wait in the buffer ports P1, P2, P3 and/or P4, during the treatment on the carried wafer substrate and/or until the treatment system receives the carried wafer substrate.

As explained above, the provision of the buffer port P1 to P4 enables the substrate carriage 2 to wait until treatment in a certain treatment system is completed. Therefore, no substrate carriage 2 becomes an obstruction on the conveying route 1. In particularly, a number of substrate carriages 2 do not form a line in front of a treatment system having a slow process speed. Thus no substrate carriage 2 is obstructed.

As a result, all the substrate carriages 2 effectively carry the wafer substrates to the respectively required treatment systems M, thereby promoting the production efficiency.

It should be mentioned that the first embodiment has the four buffer ports P1 to P4 along the conveying route 1, but the number of buffer ports is not limited, which may be decided according to the number of selected treatment systems or all the treatment system on the conveying route.

In the first embodiment, the buffer ports P1 to P4 are provided flush with the conveying route 1, but the position of the buffer port is not limited to the embodiment. For example, the buffer port P may be provided on a plane over or under the conveying route 1. In short, it is only required to temporarily remove the substrate carriage 2 from the conveying route 1.

Additionally, the necessary treatment systems for a wafer substrate are specified by identification as described in the first embodiment. Reversely, the unnecessary treatment systems can be specified. If the unnecessary treatment systems are continuously arrayed along the conveying route 1, the substrate carriage can carry the wafer substrate without stopping the unnecessary treatment systems.

For example, a production line is formed by arraying the treatment systems corresponding to processing steps for various types of semiconductor devices. When a certain type is manufactured in the production line, the CPU selects only the treatment systems required for treating the wafer substrate of that type, and sends commands based on the selected identifications to the substrate carriage 2, thereby the wafer substrate is carried to only the necessary treatment systems. In consequence, general-purpose properties are given to the production line.

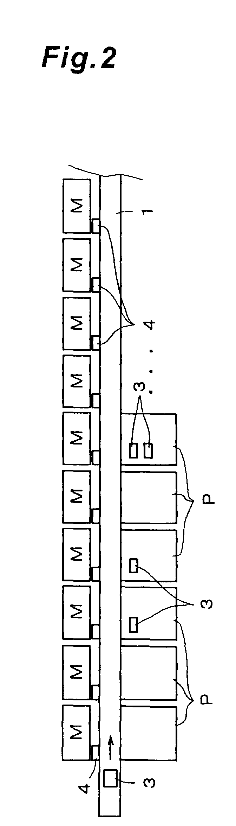

The second embodiment shown in FIG. 2 differs from the first embodiment in that the conveying route 1 is composed of belt conveyor, and the clean box 3 containing the wafer substrate to be treated is directly mounted on the conveying route 1. In the second embodiment, the conveying route 1 moves, so that the clean boxes 3 on the conveying route 1 can be moved in the direction X illustrated with the arrow at a predetermined speed, even though the substrate carriage 2 as described in the first embodiment is not provided. In other words, the above clean box 3 is a carriage of the present invention.

Note that the treatment systems M arrayed in line along the conveying route 1 are the same as those in the first embodiment.

In the second embodiment, however, the buffer ports P are respectively provided at positions corresponding to all the treatment systems M.

The above clean box 3 has an ID sensor for reading an identification ID4 installed in each treatment system M, and moves forward while reading the identifications ID4. This ID information is sent to a CPU as a controller (not shown), so that the CPU tracks the positions of clean box 3.

When the clean box 3 reaches a required treatment system M, the CPU controls receiving means for receiving wafer substrates, provided in each treatment system M, to receive the clean box 3 with the wafer substrate, thereafter the receiving means extracts the wafer substrate from the clean box 3 and then loads it to a treating section.

The production line of the second embodiment has moving means (not shown), such as robot, for moving the clean box 3 from the conveying route 1 to the buffer port P and moving it back from the buffer port P to the conveying route 1. The moving means is also controlled by CPU.

In short the CPU controls the receiving means and the moving means in response to the information of the identification ID4 read by the clean box 3.

A method for manufacturing the semiconductor devices in the production line of the second embodiment will be now explained.

The clean box 3 is loaded with the wafer substrate, and stationed on the conveying route 1, and then is moved in the direction illustrated with the arrow while reading each identification ID4 of the treatment systems M.

When the clean box 3 reaches a required treatment system M, the clean box 3 is brought into the treatment system M by control of the CPU, and the wafer substrate is treated. After the treatment of the wafer substrate, the clean box 3 receives the treated wafer substrate, and then is returned to the conveying route 1. The returned clean box 3 on the conveying route 1 moves forward to the next required treatment system M with the conveying route 1. Repeating the above steps, the wafer substrate further undergoes the required treatments, thereby manufacturing the semiconductor device.

Meanwhile, if the treatment system M to which the clean box 3 carries the wafer substrate is in use, the clean box 3 waits in the buffer port P similar to the case of the substrate carriage 2 of the first embodiment.

On occasion the clean box 3 waits in the buffer port P during the treatment of the wafer substrate.

The clean box 3 waits in the buffer port P as described above, so that the following clean boxes 3 can pass the waiting clean box 3. Hence, the wafer substrates are effectively conveyed to and treated in the required treatment systems M.

If the conveying route 1 is made of belt conveyor as described in the second embodiment, a plurality of carriages can be simultaneously moved by a belt conveyor, so that each individual control over the carriages is not necessary. Note that in use of the belt conveyor, the provision of buffer ports is necessary for stopping certain clean boxes 3 at required positions.

In order to stop a clean box 3 on the belt conveyor, the entire conveying route 1 must stop. That is when a plurality of clean boxes 3 are on the conveying route 1, all the clean boxes 3 on the conveying route 1 are simultaneously stopped. This results in the inefficiencies of conveyance and process, but such inconveniences are not produced by providing the buffer ports.

The clean box 3 is directly mounted on the belt conveyor as the conveying route in the second embodiment, but it may be mounted on a tray capable of reading the identification ID4 and moved.

Moreover, the means for moving the clean box 3 or the tray, mounted with the clean box 3, between the conveying route 1 and the buffer port P is not limited to the aforementioned robot. For example, if the buffer port P is provided flush with the belt conveyor, the belt conveyor can be provided with a direction changing member that turns toward the side, thereby the clean box 3 may be moved between the direction changing member and the buffer port P.

Similarly to the first embodiment, the buffer port P can be provided on a plane different from that of the conveying route 1.

The production line for the semiconductor devices according to the present invention does not always include all the processes for manufacturing the semiconductor device. For example, the production line may include the processes only for forming specific films. In this case, other films can be formed in another production line. Hence, the production line is allowed to use in combination with a production line called a bay system in which treatment systems are randomly arranged, and/or a line in which the wafer substrates are manually carried to each treatment system.

According to the first invention, a carriage is temporarily moved from a conveying route to a buffer port, so that any carriage waiting for completing the previous treatment in a certain treatment system does not obstruct advance of the following carriages.

The following carriages pass the waiting carriage at the buffer port and convey wafer substrates to the required treatment systems ahead, thus effectively using the treatment systems.

According to the second invention, a carriage waiting for treatment in a treatment system having a slow process speed is temporarily moved to a buffer port, so that the carriages do not form a line on a convey route to obstruct advance of the following carriages.

According to the third invention, a plurality of carriages on the conveying route is simultaneously moved by a single belt, resulting in no necessity of individually controlling the carriages.

Even in the case that the conveying route itself moves, only a specific carriage is temporarily moved to the buffer port. In other words, the remaining carriages continue to travel, while only the specific carriage is stopped in the entire moving flow by being temporarily moved to the buffer port. As a result, the carriages not needing to stop continue moving, resulting in improvement of the conveying efficiency.

It will of course be understood that the present invention has been described above purely by way of example, and modifications of detail can be made within the scope of the invention.

## Claims

1. A production line for semiconductor devices, having a section in which a plurality of treatment systems (M, M1-M4) are arrayed in line and a conveying route (1) provided along the treatment systems, comprising:
buffer ports (P1 -P4) respectively provided at positions corresponding to the predetermined treatment systems (M1 -M4) of all the treatment systems and near the conveying route (1), for allowing carriages (2, 2a-2c, 3) loaded with wafer substrates and travelling on the conveying route (1) to be temporarily moved thereto.

2. The production line for semiconductor devices according to claim 1, wherein said buffer ports (P1 -P4) are respectively provided at positions corresponding to the treatment systems (M), each having a slow process speed, of all the treatment systems (M), and near the conveying route (1).

3. The production line for semiconductor devices according to claim 1 or claim 2, wherein the conveying route (1) includes a belt conveyor.
